Europäisches Patentamt

European Patent Office

Office européen des brevets

(19)

(11) EP 0 417 973 B1

(12) # EUROPEAN PATENT SPECIFICATION

(45) Date of publication and mention
of the grant of the patent:
**31.01.1996 Bulletin 1996/05**

(51) Int Cl.6: **G11C 7/06**

(21) Application number: **90309741.8**

(22) Date of filing: **05.09.1990**

(54) **Amplifier circuit having two inverters**

Verstärkerschaltung mit zwei Invertern

Circuit amplificateur avec deux inverseurs

(84) Designated Contracting States:
**DE FR GB**

(30) Priority: **12.09.1989 JP 234657/89**

(43) Date of publication of application:
**20.03.1991 Bulletin 1991/12**

(73) Proprietors:
- **KABUSHIKI KAISHA TOSHIBA
  Kawasaki-shi, Kanagawa-ken 210, Tokyo (JP)**
- **TOSHIBA MICRO-ELECTRONICS
  CORPORATION
  Kawasaki-ku, Kawasaki-shi,
  Kanagawa-ken (JP)**

(72) Inventors:
- **Uchida, Masanori, c/o Intellectual Property Div.
  Tokyo (JP)**
- **Tizuka, Tetsuya, c/o Intellectual Property Div.
  Tokyo (JP)**

(74) Representative: **Freed, Arthur Woolf et al
London WC2A 3LS (GB)**

(56) References cited:
**EP-A- 0 143 591**       **WO-A-88/09034**

## Description

This invention concerns an amplifier circuit which is suitable for use as a sense amplifier in a semiconductor memory device.

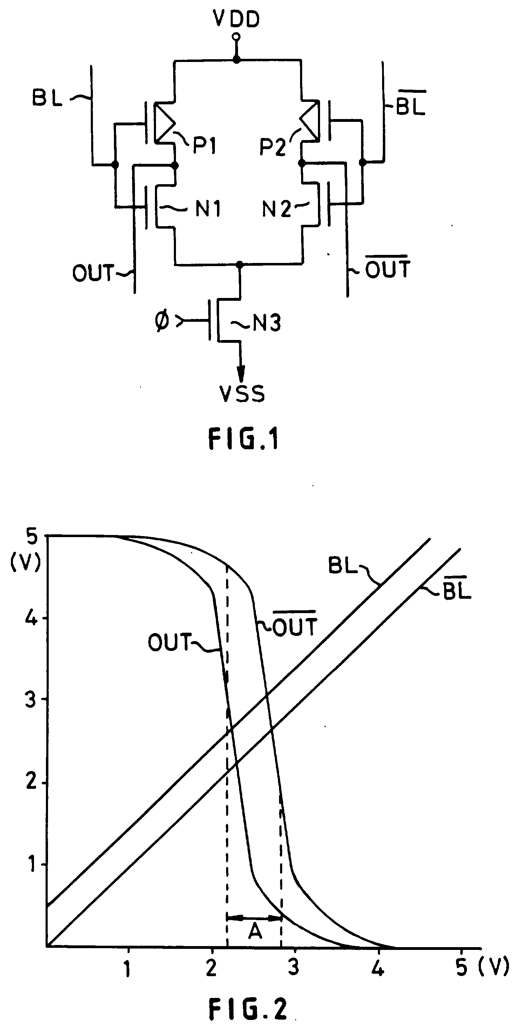

Conventionally, amplifier circuits are used as sense amplifiers in semiconductor memory devices. The number of sense amplifiers used increases in proportion to increased integration, especially in DRAM device. Thus, a sense amplifier with low power consumption and which is composed of limited circuit elements is required. To reduce the power consumption and the number of circuit elements used, the inventors attempted to modify the amplifier circuit shown in **FIG.1**.

In **FIG.1**, the references **P1** and **P2** represent P-type MOS transistors and **N1** to **N3** represent N-type MOS transistors. In this sense amplifier, output signals **OUT** and $\overline{\text{OUT}}$ are obtained by amplifying the difference in voltage between the bit lines **BL** and $\overline{\text{BL}}$ when the **MOS** transistor N3 is activated in response to an enable signal Φ. Since the output **OUT** and $\overline{\text{OUT}}$ are achieved by the switching operation of the inverters composed of **CMOS** circuits, a reduction of the power consumption is achieved. However, in this amplifier circuit, the sensing margin is insufficient, as will be explained in detail below.

**FIG.2** shows a characteristic curve of the amplifier circuit shown in **FIG.1** in the condition where the VDD is 5 volt and VSS is ground level. In **FIG.2**, the X-axis represents the input voltage and the Y-axis represents the output voltage. **BL** and $\overline{\text{BL}}$ represent input signals to the amplifier circuit.

The outputs **OUT** and $\overline{\text{OUT}}$ are achieved as the inverted signals of the input signals **BL** and $\overline{\text{BL}}$, when the voltage of the respective input signals exceed the predetermined threshold voltages of the inverter circuits. If the sensing area is defined by a area wherein the amplification factor is more than 3, the sensing area of the circuit shown in **FIG.1** is illustrated by **A**. Namely, the sensing area is narrow. Thus, the circuit shown in **FIG.1** is insufficient as a sense amplifier in a memory device, the sensing margin being too small with respect to the fluctuation of the input signals.

PCT patent application WO/88/09034 discloses a circuit with a sense amplifier having power supply terminals coupled via transistors to the two inverters of a differential amplifier.

Therefore, an object of the present invention is to provide an amplifier circuit which has a wide operation area and low power consumption.

Another object of the present invention is to provide an amplifier circuit which is suitable for a sense amplifier in a memory device.

To achieve the objects, this invention provides an amplifier circuit comprising:

first inverter circuit means responsive to a first power source voltage and a second power source voltage, for outputting a first output signal in response to a first input signal;
second inverter circuit means responsive to the first power source voltage and the second power source voltage, for outputting a second output signal in response to a second input signal;
first circuit means for supplying the first power source voltage to the first and the second inverter circuit means, including a first MOS transistor of a first conductivity type having a gate electrode supplied with the output signal of the first inverter circuit means; and
second circuit means for supplying the second power source voltage to the first and the second inverter circuit means,
and a second MOS transistor of the first conductivity type in parallel with said first MOS transistor and having a gate electrode supplied with the output signal of the second inverter circuit means.

The accompanying drawings, which are incorporated in and constitute a part of the specification, illustrate an embodiment of the invention, and, together with the description, serve to explain the principles of the invention. Referring now to the drawings, like reference characters designate like or corresponding parts throughout the several views. In the drawings:

**FIG.1** is a circuit diagram of an amplifier circuit developed by the inventors;
**FIG.2** is a characteristic curve of the circuit shown in **FIG**.1;
**FIG.3** is a circuit diagram of a first embodiment of the present invention;
**FIG.4** is a characteristic curve of the circuit shown in **FIG**.3;
**FIG.5** is a circuit diagram of a second embodiment of the present invention;
**FIG.6** is a circuit diagram of a third embodiment of the present invention;
**FIG.7** is a circuit diagram of a fourth embodiment of the present invention;
**FIG.8** is a circuit diagram of a fifth embodiment of the present invention;
**FIG.9** is a circuit diagram of a sixth embodiment of the present invention;
**FIG.10** is a circuit diagram of a seventh embodiment of the present invention; and
**FIG.11** is a circuit diagram of a eighth embodiment of the present invention;
**FIG.12** is a circuit diagram of a ninth embodiment of the present invention.

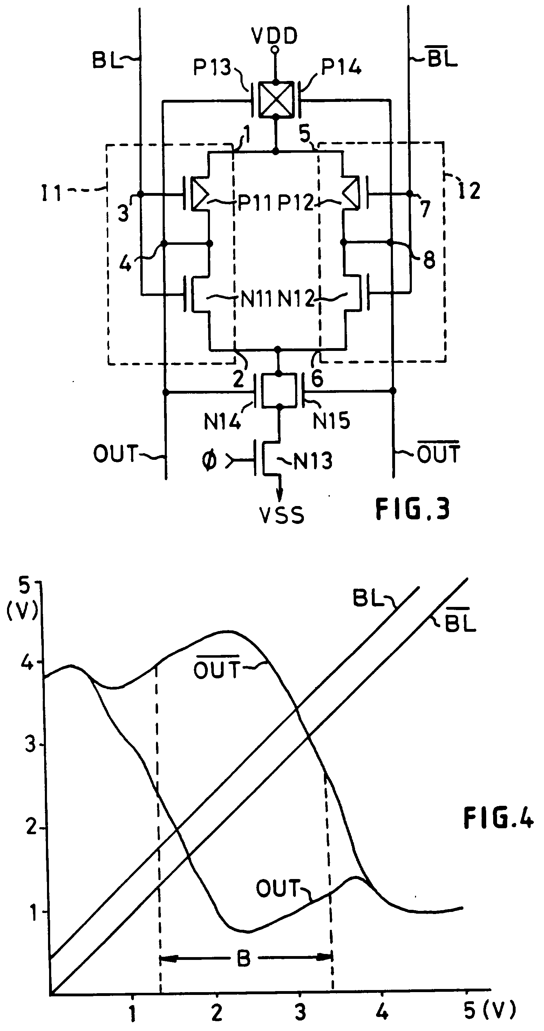

Referring now to the drawings, the present invention will be explained. **FIG.3** is a circuit diagram of a first embodiment of the present invention. In the following explanation, the word "terminal" is used for convenience of explanation. However, the "terminal" may be just a wiring layer. In this embodiment of the present invention, there is provided a first inverter circuit **I1**.

The first inverter **I1** includes a first power source terminal **1**, a second power terminal **2**, a first input terminal **3** and a first output terminal **4**. The first input terminal **3** is connected to a bit line **BL** in a DRAM device (not shown), in this embodiment.

The first inverter circuit **I1** includes an N-type **MOS** transistor N11 and a P-type **MOS** transistor **P11**. The source electrode of the N-type **MOS** transistor N11 is connected to the second power source terminal **2** and the gate electrode thereof is connected to the first input terminal **3**. The source electrode of the P-type **MOS** transistor **P11** is connected to the first power source terminal **1**, and the gate electrode of the P-type **MOS** transistor **P11** is connected to the first input terminal **3**. The drain electrodes of the transistors N11 and **P11** are connected in cdmmon and are connected to the first output terminal **4**.

The second inverter circuit **I2** includes a third power source terminal **5**, a fourth power source terminal **6**, a second input terminal **7** and a second output terminal **8**.

The second inverter circuit **I2** includes a P-type **MOS** transistor **P12** and an N-type **MOS** transistor **N12**. The source electrode of the transistor **N12** is connected to the fourth power source terminal **4**. The source electrode of the transistor **P12** is connected to the third power source terminal **5**. The gate electrodes of the transistors **N12** and **P12** are connected to the second input terminal **7**, and the drain electrodes thereof are connected in common and to the second output terminal **8**.

This embodiment further comprises two N-type **MOS** transistors **N14** and **N15**. The drain electrodes of the transistors **N14** and **N15** are connected in common and to the second and the fourth terminals **2** and **6**. The gate electrode of the transistor **N14** is supplied with the output of the first inverter circuit **I1**, and the gate electrode of the transistor **N15** is supplied with the output of the second inverter circuit **I2**.

The source electrodes of the transistors **N14** and **N15** are connected in common and are supplied with the power source voltage Vss through an N-type **MOS** transistor **N13** which is controlled by a switching signal Φ.

This embodiment further includes two P-type **MOS** transistors **P13** and **P14**. The drain electrodes of the transistors **P13** and **P14** are connected in common and to the first and the third terminals **1** and **5**. The source electrodes of the transistors **P13** and **P14** are connected in common and are supplied with the power source voltage VDD. The gate electrode of the transistor **P13** is supplied with the output of the first inverter circuit **I1**, and the gate electrode of the transistor **P14** is supplied with the output of the second inverter circuit **I2**.

In this circuit, when the voltage level of the bit line **BL** is high and the voltage level of the bit line $\overline{\textbf{BL}}$ is low, the output level of **OUT** becomes low and that of $\overline{\textbf{OUT}}$ becomes high. Thus, the gate voltage of the transistor **N14** is lowered and the conductivity thereof is lowered. Therefore, the source potential of the transistor **N11** is raised and the conductivity thereof is lowered. Namely, due to the N-type **MOS** transistor **N14**, a negative feedback loop is formed between the first inverter circuit **I1** and the transistor **N14**. In other words, the transistor **N14** operates to bring the threshold voltage of the first inverter circuit **I1** closer to the input voltage of the bit line **BL**.

In the same way, the transistor **N15** operates to bring the threshold voltage of the second inverter circuit **I2** closer to the input voltage of the bit line $\overline{\textbf{BL}}$ .

On the other hand, when the voltage level of the bit line **BL** becomes low, the output **OUT** becomes high level. Thus, the conductivity of the P-type **MOS** transistor **P13** is lowered and the source voltage of the transitor **P11** is also lowered. Thus, the conductivity of the transistor **P11** is lowered and the potential of the output **OUT** is also lowered. Namely, the P-type **MOS** transistor **P13** functions to form a negative feedback loop with the first inverter circuit **I1** with respect to the rise of the voltage level of **OUT**.

Similarly, the transistor **P14** forms a negative feedback loop with the second inverter **I2** with respect to the rise of the voltage level $\overline{\textbf{OUT}}$ .

**FIG.4** shows the characteristic curve of the circuit shown in **FIG.3** in the condition wherein the VDD is 5.0 volt and the VSS is ground level. As shown in **FIG.4**, the sensing area (illustrated by **B**) is significantly expanded compared with that of the circuit of **FIG.1**. Namely, the amplifier circuit of **FIG.3** can sense the input voltage in the range between about 1.2 volt to 3.4 volt. Thus, the sensing margin is significantly increased.

Furthermore, since the inverters **I1** and **I2** are composed of **CMOS** circuits, the power consumption is significantly reduced.

Still furthermore, the circuit construction is symmetrical. Thus, the sensing is performed in a balanced condition.

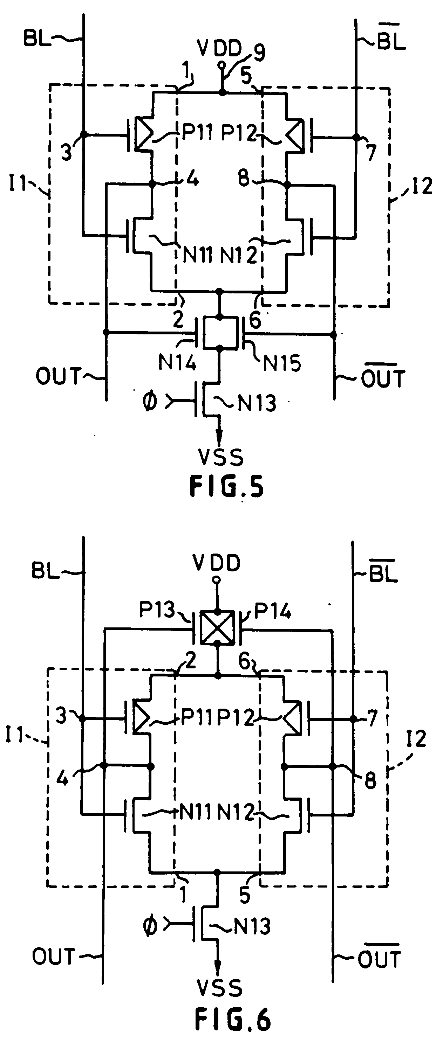

**FIG.5** is a circuit diagram of a second embodiment of the present invention. In this embodiment, the two P-type **MOS** transistors **P13** and **P14** in the first embodiment shown in **FIG.3** are omitted, and the power source voltage VDD is applied to the inverter circuits **I1** and **I2** through a wiring **9**.

In this embodiment, a negative feedback loop with respect to the fall of the output voltage level is also formed. Thus, the sensing area is expanded and the sensing margin is increased.

**FIG.6** is a circuit diagram of a third embodiment of the present invention. In this embodiment, the two N-type **MOS** transistors **N14** and **N15** in the first embodiment shown in **FIG.3** are omitted, and the power source voltage Vss is applied to the inverter circuits **I1** and **I2** through the MOS transistor **N13**. In this embodiment, a negative feedback loop with respect to the rise of the output level is formed to expand the sensing area.

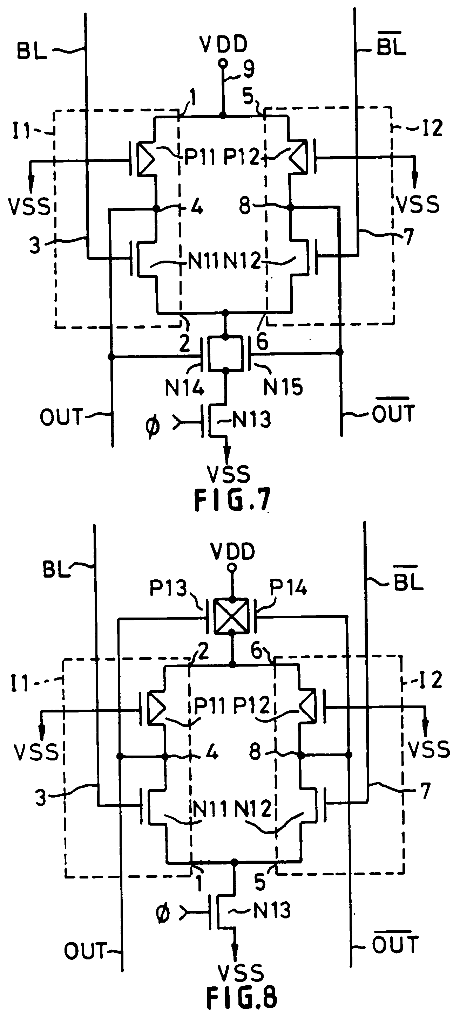

**FIG.7** is a circuit diagram of a fourth embodiment of the present invention. In this embodiment, the inverter circuit **I1** includes an N-type **MOS** transistor **N11** and a P-type **MOS** transistor **P11** of normally-ON type. Namely, the gate electrode of the P-type **MOS** transistor **P11** is supplied with a low level power source voltage VSS. Similarly, the second inverter **I2** includes an N-type **MOS** transistor **N12** and a normally-ON type transistor **P12**.

In this circuit, the gate electrodes of only the N-type **MOS** transistors **N11** and **N12** are connected to the bit lines **BL** and $\overline{\text{BL}}$. Thus, the capacitance due to the gate electrodes of the P-type **MOS** transistors **P11** and **P12** is eliminated and the circuit is suitable for high speed sensing.

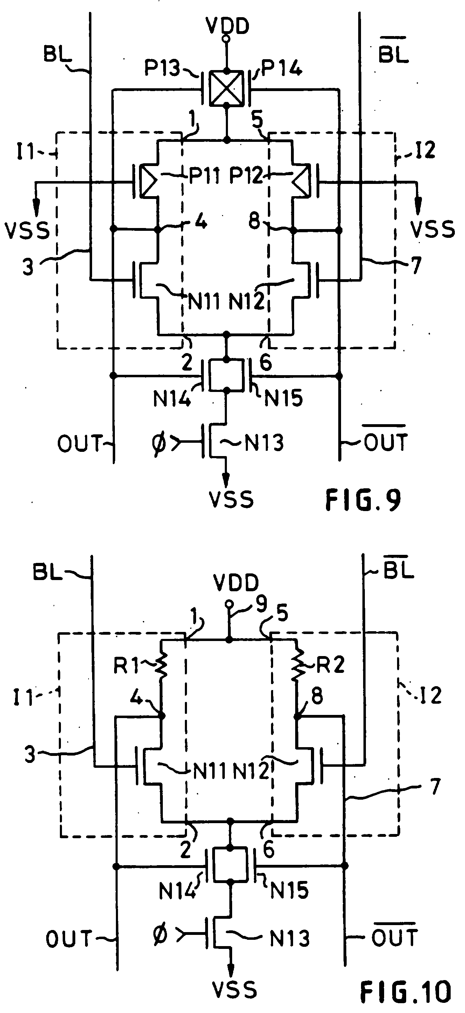

**FIG.8** is a circuit diagram of a fifth embodiment of the present invention. In this embodiment, the inverter circuits **I1** and **I2** of the third embodiment shown in **FIG.6** are replaced by inverter circuits which include an N-type **MOS** transistor and a normally-ON type **MOS** transistor.

**FIG.9** is a circuit diagram of a sixth embodiment of the present invention. In this embodiment, the inverter circuit of the first embodiment shown in **FIG.3** is replaced by an inverter circuit which includes an N-type **MOS** transistor and a normally-ON type **MOS** transistor.

**FIG.10** is a circuit diagram of a seventh embodiment of the present invention. In this embodiment, the inverter circuit of the second embodiment shown in **FIG.5** is replaced by a inverter circuit which includes an N-type **MOS** transistor and a resistor.

Namely, the first inverter circuit **I1** includes an N-type MOS transistor **N11** and a resistor **R1**. The gate electrode of transistor **N11** is connected to the input terminal **3** and is supplied with the input signal. One end of the resistor **R1** is supplied with the power source voltage VDD through a wiring **9**, and the other end is connected to the drain electrode of the transistor **N11**. The connection of the resistor **R1** and the drain electrode of the transistor **N11** form the output terminal **4**. Similarly, the inverter circuit **I2** includes a resistor **R2** and a MOS transistor **N12**.

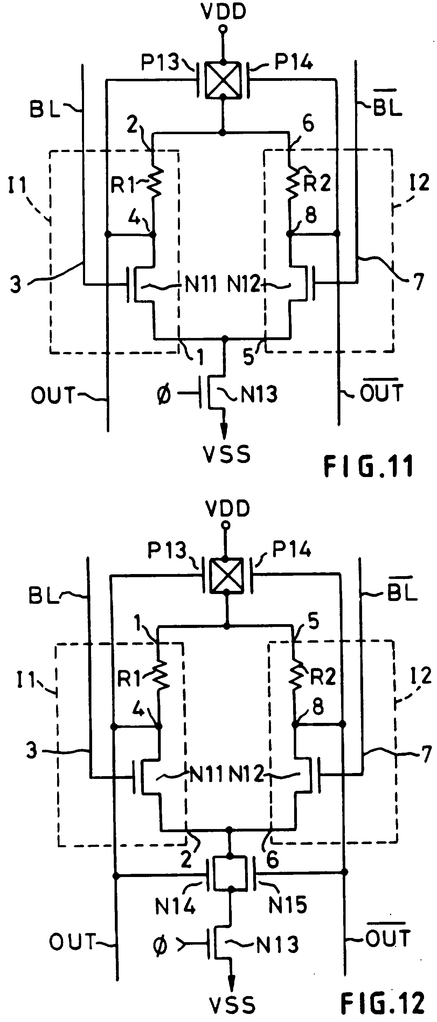

**FIG.11** is a circuit diagram of a eighth embodiment of the present invention. In this embodiment, as in the seventh embodiment explained above, the inverter circuit in the third embodiment shown in **FIG.6** is replaced by an inverter circuit which includes an N-type **MOS** transistor and a resistor.

**FIG.12** is a circuit diagram of a ninth embodiment of the present invention. In this embodiment, as in the seventh embodiment, the inverter circuit of the first embodiment shown in **FIG.3** is also replaced by an inverter which includes an N-type **MOS** transistor and a resistor.

The present invention has been described with respect to specific embodiments. However, other embodiments based on the principles of the present invention should be obvious to those of ordinary skill in the art within the scope of the appended claims.

**Claims**

1. An amplifier circuit comprising:

first inverter circuit means (I1) responsive to a first power source voltage (VDD or Vss) and a second power source voltage (VSS or Vdd), for outputting a first output signal (OUT) in response to a first input signal (BL);

second inverter circuit means (I2) responsive to the first power source voltage and the second power source voltage, for outputting a second output signal (OUT) in response to a second input signal (BL);

first circuit means (N14, N15, or P13, P14) for supplying the first power source voltage to the first and the second inverter circuit means, including a first MOS transistor (N14 or P13) of a first conductivity type having a gate electrode supplied with the output signal of the first inverter circuit means (I1); and

second circuit means (P13, P14; N14, N15) for supplying the second power source voltage to the first and the second inverter circuit means, characterized by a second MOS transistor (N15 or P14) of the first conductivity type in parallel with said first MOS transistor (N14 or P13) and having a gate electrode supplied with the output signal of the second inverter circuit means (I2).

2. The amplifier circuit of claim 1, wherein the first power source voltage (Vss) is lower than the second power source voltage (VDD), and the first and second MOS transistors (N14, N15) are N-type MOS transistors.

3. The amplifier circuit of claim 1, wherein the first power source voltage (VDD) is higher than the second power source voltage (Vss), and the first and the second MOS transistors (P13, P14) are P-type MOS transistors.

4. The amplifier circuit of claim 2 or claim 3, wherein the first inverter circuit means (I1) includes;

a third MOS transistor (N11 or P11) of the first conductivity type having a source electrode supplied with the first power source voltage (Vss or VDD), a drain electrode and a gate electrode supplied with the first input signal;

a fourth MOS transistor (P11 or N11) of a second conductivity type, having a source electrode supplied with the second power source voltage (VDD or Vss), a drain electrode connected to the drain electrode of the third MOS transistor and a gate electrode supplied with the first input signal; and

the second inverter circuit means (I2) includes: a fifth MOS transistor (N12 or P12) of the first conductivity type, having a source electrode supplied with the first power source voltage, a drain electrode and a gate electrode supplied with the second input signal, a sixth MOS transistor (P12 or N12) of the second conductivity type having a source electrode supplied with the second power source voltage, a drain electrode connected to the drain electrode of the fifth MOS transistor and a gate electrode supplied with the second input signal.

5. The amplifier circuit of claim 2, wherein the first inverter circuit means (I1) includes a third MOS transistor (N11) of the first conductivity type having a source electrode supplied with the first power source voltage (Vss), a drain electrode and a gate electrode supplied with the first input signal, and a fourth MOS transistor (P11) of a second conductivity type having a source electrode supplied with the second power source voltage (VDD), a drain electrode connected to the drain electrode of the third MOS transistor and a gate electrode supplied with the first power source voltage (Vss); and

the second inverter circuit means (I2) includes a fifth MOS transistor (N12) of the first conductivity type having a source electrode supplied with the first power source voltage (Vss), a drain electrode and a gate electrode supplied with the second input signal, a sixth MOS transistor (P12) of the second conductivity type having a source electrode supplied with the second power source voltage (VDD), a drain electrode connected to the drain electrode of the fifth MOS transistor and a gate electrode supplied with the second power source voltage (Vss).

6. The amplifier circuit of claim 3, wherein the first inverter circuit (I1) includes a third MOS transistor (N11) of a second conductivity having a source electrode supplied with the second power source voltage (Vss), a drain electrode and a gate electrode supplied with the first input signal, and a fourth MOS transistor (P11) of the first conductivity type having a source electrode supplied with the first power source voltage (VDD), a drain electrode connected to the drain electrode of the third MOS transistor and a gate electrode supplied with the second power source voltage (Vss); and

the second inverter circuit means (I2) includes a fifth MOS transistor (N12) of the second conductivity type having a source electrode supplied with the second power source voltage (Vss), a drain electrode and a gate electrode supplied with the second input signal, a sixth MOS transistor (P12) of the first conductivity type having a source electrode supplied with the first power source voltage (VDD), a drain electrode connected to the drain electrode of the fifth MOS transistor and a gate electrode supplied with the second power source voltage (Vss).

7. The amplifier of claim 2, wherein the first inverter circuit (I1) includes a third MOS transistor (N11) of the first conductivity type having a source electrode supplied with the first power source voltage (Vss), a drain electrode and a gate electrode supplied with the first input signal, a first resistor (R1) having a first end supplied with the second power source voltage (VDD) and a second end connected to the drain electrode of the third MOS transistor (N11); and

the second inverter circuit means (I2) includes a fourth MOS transistor (N12) of the first conductivity type having a source electrode supplied with the first power source voltage (Vss), a drain electrode and a gate electrode supplied with the second input signal, a second resistor (R2) having a third end supplied with the second power source voltage (VDD) and a fourth end connected to the drain electrode of the fourth MOS transistor (N12).

8. The amplifier of claim 3, wherein the first inverter circuit means (I1) includes a third MOS transistor (N11) of a second conductivity type having a source electrode supplied with the second power source voltage (Vss), a drain electrode and a gate electrode supplied with the first input signal, a first resistor (R1) having a first end supplied with the first power source voltage (VDD) and a second end connected to the drain electrode of the third MOS transistor (N11); and

the second inverter circuit means (I2) includes a fourth MOS transistor (N12) of the second conductivity type having a source electrode supplied with the first power source voltage (VDD), a drain electrode and a gate electrode supplied with the second input signal, a second resistor (R2) having a third end supplied with the first power source voltage (VDD) and a fourth end connected to the drain electrode of the fourth MOS transistor (N12).

9. An amplifier circuit according to claim 1, comprising said second circuit means (P13, P14; N14, N15) for supplying the second power source voltage to the first and the second inverter cirduit means, including a third MOS transistor (P13, N14) of a second conductivity type having a gate electrode supplied with the output of the first inverter circuit means and a fourth MOS transistor (P14, N15) of the second conductivity type having a gate electrode supplied with the output of the second inverter circuit means.

10. The amplifier circuit of claim 9, wherein the first inverter circuit means includes a fifth MOS transistor (N11) of the first conductivity type having a source electrode supplied with the first power source voltage, a drain electrode and a gate electrode supplied with the first input signal, a sixth MOS transistor (P11) of the second conductivity type having a source electrode supplied with the second power source voltage, a drain electrode connected to the drain electrode of the fifth MOS transistor and a gate electrode; and

the second inverter circuit means (I2) includes a seventh MOS transistor (N12) of the first conductivity type having a source electrode supplied with the first power source voltage, a drain electrode and a gate electrode supplied with the second input signal, an eighth MOS transistor (P12) of the second conductivity type having a source electrode supplied with the second power source voltage, a drain electrode connected to the drain electrode of the seventh MOS transistor and a gate electrode and the gate electrodes of the sixth and eighth MOS transistors are supplied either with the first and second input signals, respectively, or with the first power source voltage.

11. The amplifier circuit of claim 9, wherein the first inverter circuit includes a fifth MOS transistor (N11) of the first conductivity type having a source electrode supplied with the first power source voltage, a drain electrode and a gate electrode supplied with the first input signal, a first resistor (R1) having a first end connected to the drain electrode of the fifth MOS transistor and a second end supplied with the second power source voltage;

the second inverter circuit includes a sixth MOS transistor (N12) of the first conductivity type having a source electrode supplied with the first power source voltage, a drain electrode and a gate electrode supplied with the second input signal, a second resistor (R2) having a third end connected to the drain electrode of the sixth MOS transistor and a fourth end supplied with the second power source voltage.

**Patentansprüche**

1. Verstärkerschaltung mit:

einer ersten Inverterschaltungseinrichtung (I1), die auf eine erste Stromquellenspannung (VDD oder Vss) und eine zweite Stromquellenspannung (VSS oder Vdd) anspricht, zum Ausgeben eines ersten Ausgangssignals (OUT) als Antwort auf ein erstes Eingangssignal (BL);
einer zweiten Inverterschaltungseinrichtung (I2), die auf die erste Stromquellenspannung und die zweite Stromquellenspannung anspricht, zum Ausgeben eines zweiten Ausgangssignals (OUT) als Antwort auf ein zweites Eingangssignal (BL);
einer ersten Schaltungseinrichtung (N14, N15 oder P13, P14) zum Liefern einer ersten Stromquellenspannung an die erste und die zweite Inverterschaltungseinrichtung, mit einem ersten MOS-Transistor (N14 oder P13) eines ersten Leitungstyps mit einer Gate-Elektrode, die mit dem Ausgangssignal der ersten Inverterschaltungseinrichtung (I1) versorgt wird; und einer zweiten Schaltungseinrichtung (P13, P14; N14, N15) zum Liefern der zweiten Stromquellenspannung an die erste und die zweite Inverterschaltungseinrichtung,
dadurch gekennzeichnet, daß ein zweiter MOS-Transistor (N15 oder P14) des ersten Leitungstyps mit dem ersten MOS-Transistor (N14 oder P13) parallel liegt und eine Gate-Elektrode aufweist, die mit dem Ausgangssignal der zweiten Inverterschaltungseinrichtung (I2) versorgt wird.

2. Verstärkerschaltung nach Anspruch 1, wobei die erste Stromquellenspannung (Vss) niedriger ist als die zweite Stromquellenspannung (VDD) und der erste und der zweite MOS-Transistor (N14, N15) n-MOS-Transistoren sind.

3. Verstärkerschaltung nach Anspruch 1, wobei die erste Stromquellenspannung (VDD) höher ist als die zweite Stromquellenspannung (Vss) und der erste und der zweite MOS-Transistor (P13, P14) p-MOS-Transistoren sind.

4. Verstärkerschaltung nach Anspruch 2 oder 3, wobei die erste Inverterschaltungseinrichtung (I1) aufweist:

einen dritten MOS-Transistor (N11 oder P11) des ersten Leitungstyps mit einer Source-Elektrode, die mit der ersten Stromquellenspannung (Vss oder VDD) versorgt wird, einer Drain-Elektrode und einer Gate-Elektrode, die mit dem ersten Eingangssignal versorgt wird;
einen vierten MOS-Transistor (P11 oder N11) eines zweiten Leitungstyps mit einer Source-Elektrode, die mit der zweiten Stromquellenspannung (VDD oder Vss) versorgt wird, einer Drain-Elektrode, die mit der Drain-Elektrode des dritten MOS-Transistors verbunden ist, und einer Gate-Elektrode, die mit dem ersten Eingangssignal versorgt wird; und
die zweite Inverterschaltungseinrichtung (I2) aufweist:
einen fünften MOS-Transistor (N12 oder P12) des ersten Leitungstyps mit einer Source-Elektrode, die mit der ersten Stromquellenspannung versorgt wird, einer Drain-Elektrode und einer Gate-Elektrode, die mit dem zweiten Eingangssignal versorgt wird, einen sechsten MOS-Transistor (P12 oder N12) des zweiten Leitungstyps mit einer Source-Elektrode, die mit der zweiten Stromquellenspannung versorgt wird, einer Drain-Elektrode, die mit der Drain-Elektrode des fünften MOS-Transistors verbunden ist und einer Gate-Elektrode, die mit dem zweiten Eingangssignal versorgt wird.

**5.** Verstärkerschaltung nach Anspruch 2, wobei die erste Inverterschaltungseinrichtung (I1) aufweist: einen dritten MOS-Transistor (N11) des ersten Leitungstyps mit einer Source-Elektrode, die mit der ersten Stromquellenspannung (Vss) versorgt wird, einer Drain-Elektrode und einer Gate-Elektrode, die mit dem ersten Eingangssignal versorgt wird, und einem vierten MOS-Transistor (P11) eines zweiten Leitungstyps mit einer Source-Elektrode, die mit der zweiten Stromquellenspannung (VDD) versorgt wird, einer Drain-Elektrode, die mit der Drain-Elektrode des dritten MOS-Transistors verbunden ist, und einer Gate-Elektrode, die mit der ersten Stromquellenspannung (Vss) versorgt wird; und

die zweite Inverterschaltungseinrichtung (I2) aufweist: einen fünften MOS-Transistor (N12) des ersten Leitungstyps mit einer Source-Elektrode, die mit der ersten Stromquellenspannung (Vss) versorgt wird, einer Drain-Elektrode und einer Gate-Elektrode, die mit dem zweiten Eingangssignal versorgt wird, einen sechsten MOS-Transistor (P12) des zweiten Leitungstyps mit einer Source-Elektrode, die mit der zweiten Stromquellenspannung (VDD) versorgt wird, einer Drain-Elektrode, die mit der Drain-Elektrode des fünften MOS-Transistors verbunden ist, und einer Gate-Elektrode, die mit der zweiten Stromquellenspannung (Vss) versorgt wird.

**6.** Verstärkerschaltung nach Anspruch 3, wobei die erste Inverterschaltung (I1) aufweist: einen dritten MOS-Transistor (N11) eines zweiten Leitungstyps mit einer Source-Elektrode, die mit der zweiten Stromquellenspannung (Vss) versorgt wird, einer Drain-Elektrode und einer Gate-Elektrode, die mit dem ersten Eingangssignal versorgt wird, und einen vierten MOS-Transistor (P11) des ersten Leitungstyps mit einer Source-Elektrode, die mit der ersten Stromquellenspannung (VDD) versorgt wird, einer Drain-Elektrode, die mit der Drain-Elektrode des dritten MOS-Transistors verbunden ist, und einer Gate-Elektrode, die mit der zweiten Stromquellenspannung (Vss) versorgt wird; und

die zweite Inverterschaltungseinrichtung (I2) aufweist: einen fünften MOS-Transistor (N12) des zweiten Leitungstyps mit einer Source-Elektrode, die mit der zweiten Stromquellenspannung (Vss) versorgt wird, einer Drain-Elektrode und einer Gate-Elektrode, die mit dem zweiten Eingangssignal versorgt wird, einen sechsten MOS-Transistor (P12) des ersten Leitungstyps mit einer Source-Elektrode, die mit der ersten Stromquellenspannung (VDD) versorgt wird, einer Drain-Elektrode, die mit der Drain-Elektrode des fünften MOS-Transistors verbunden ist und einer Gate-Elektrode, die mit der zweiten Stromquellenspannung (Vss) versorgt wird.

**7.** Verstärker nach Anspruch 2, wobei die erste Inverterschaltung (I1) aufweist: einen dritten MOS-Transistor (N11) des ersten Leitungstyps mit einer Source-Elektrode, die mit der ersten Stromquellenspannung (Vss) versorgt wird, einer Drain-Elektrode und einer Gate-Elektrode, die mit dem ersten Eingangssignal versorgt wird, einen ersten Widerstand (R1) mit einem ersten Ende, das mit der zweiten Stromquellenspannung (VDD) versorgt wird, und einem zweiten Ende, das mit der Drain-Elektrode des dritten MOS-Transistors (N11) verbunden ist; und

die zweite Inverterschaltungseinrichtung (I2) aufweist: einen vierten MOS-Transistor (N12) des ersten Leitungstyps mit einer Source-Elektrode, die mit der ersten Stromquellenspannung (Vss) versorgt wird, einer Drain-Elektrode und einer Gate-Elektrode, die mit dem zweiten Eingangssignal versorgt wird, einen zweiten Widerstand (R2) mit einem dritten Ende, das mit der zweiten Stromquellenspannung (VDD) versorgt wird, und einem vierten Ende, das mit der Drain-Elektrode des vierten MOS-Transistors (N12) verbunden ist.

**8.** Verstärker nach Anspruch 3, wobei die erste Inverterschaltungseinrichtung (I1) aufweist: einen dritten MOS-Transistor (N11) eines zweiten Leitungstyps mit einer Source-Elektrode, die mit der zweiten Stromquellenspannung (Vss) versorgt wird, einer Drain-Elektrode und einer Gate-Elektrode, die mit dem ersten Eingangssignal versorgt wird, einem ersten Widerstand (R1) mit einem ersten Ende, das mit der ersten Stromquellenspannung (VDD) versorgt wird, und einem zweiten Ende, das mit der Drain-Elektrode des dritten Transistors (N11) verbunden ist; und

die zweite Inverterschaltungseinrichtung (I2) aufweist: einen vierten MOS-Transistor (N12) des zweiten Leitungstyps mit einer Source-Elektrode, die mit der ersten Stromquellenspannung (VDD) versorgt wird, einer Drain-Elektrode und einer Gate-Elektrode, die mit dem zweiten Eingangssignal versorgt wird, einen zweiten Widerstand (R2) mit einem dritten Ende, das mit der ersten Stromquellenspannung (VDD) versorgt wird, und einem vierten Ende, das mit der Drain-Elektrode des vierten MOS-Transistors (N12) verbunden ist.

**9.** Verstärkerschaltung nach Anspruch 1, mit der zweiten Schaltungseinrichtung (P13, P14; N14, N15) zum Liefern der zweiten Stromquellenspannung an die erste und die zweite Inverterschaltungseinrichtung, mit einem dritten MOS-Transistor (P13, N14) eines zweiten Leitungstyps mit einer Gate-Elektrode, die mit dem Ausgangssignal der ersten Inverterschaltungseinrichtung versorgt wird, und einem vierten MOS-Transistor (P14, N15) des zweiten Leitungstyps mit einer Gate-Elektrode, die mit dem Ausgangssignal der zweiten Inverterschaltungseinrichtung versorgt wird.

10. Verstärkerschaltung nach Anspruch 9, wobei die erste Inverterschaltungseinrichtung aufweist: einen fünften MOS-Transistor (N11) des ersten Leitungstyps mit einer Source-Elektrode, die mit der ersten Stromquellenspannung versorgt wird, einer Drain-Elektrode und einer Gate-Elektrode, die mit dem ersten Eingangssignal versorgt wird, einen sechsten MOS-Transistor (P11) des zweiten Leitungstyps mit einer Source-Elektrode, die mit der zweiten Stromquellenspannung versorgt wird, einer Drain-Elektrode, die mit der Drain-Elektrode des fünften MOS-Transistors verbunden ist, und einer Gate-Elektrode; und

die zweite Inverterschaltungseinrichtung (I2) aufweist: einen siebenten MOS-Transistor (N12) des ersten Leitungstyps mit einer Source-Elektrode, die mit der ersten Stromquellenspannung versorgt wird, einer Drain-Elektrode und einer Gate-Elektrode, die mit dem zweiten Eingangssignal versorgt wird, einen achten MOS-Transistor (P12) des zweiten Leitungstyps mit einer Source-Elektrode, die mit der zweiten Stromquellenspannung versorgt wird, einer Drain-Elektrode, die mit der Drain-Elektrode des siebenten MOS-Transistors verbunden ist, und einer Gate-Elektrode und die Gate-Elektroden des sechsten und des achten MOS-Transistors entweder mit dem ersten bzw. zweiten Eingangssignal oder mit der ersten Stromquellenspannung versorgt werden.

11. Verstärkerschaltung nach Anspruch 9, wobei die erste Inverterschaltung aufweist: einen fünften MOS-Transistor (N11) des ersten Leitungstyps mit einer Source-Elektrode, die mit der ersten Stromquellenspannung versorgt wird, einer Drain-Elektrode und einer Gate-Elektrode, die mit dem ersten Eingangssignal versorgt wird, einen ersten Widerstand (R1) mit einem ersten Ende, das mit der Drain-Elektrode des fünften MOS-Transistors verbunden ist, und einem zweiten Ende, das mit der zweiten Stromquellenspannung versorgt wird;

die zweite Inverterschaltung aufweist: einen sechsten MOS-Transistor (N12) des ersten Leitungstyps mit einer Source-Elektrode, die mit der ersten Stromquellenspannung versorgt wird, einer Drain-Elektrode und einer Gate-Elektrode, die mit dem zweiten Eingangssignal versorgt wird, einen zweiten Widerstand (R2) mit einem dritten Ende, das mit der Drain-Elektrode des sechsten MOS-Transistors verbunden ist, und einem vierten Ende, das mit der zweiten Stromquellenspannung versorgt wird.

**Revendications**

1. Circuit amplificateur comprenant:

un premier circuit inverseur (I1) sensible à une première tension d'alimentation en énergie (VDD ou Vss) et à une deuxième tension d'alimentation en énergie (VSS ou Vdd), pour sortir un premier signal de sortie (OUT) en réponse à un premier signal d'entrée (BL);
un second circuit inverseur (I2) sensible à la première tension d'alimentation en énergie et à la deuxième tension d'alimentation en énergie, pour sortir un second signal de sortie (OUT) en réponse à un second signal d'entrée (BL);
un premier circuit (N14, N15, ou P13, P14) pour fournir la première tension d'alimentation en énergie au premier et au second des circuits inverseurs, incluant un premier transistor MOS (N14 ou P13) d'un premier type de conductibilité ayant une électrode de grille alimentée avec le signal de sortie du premier circuit inverseur (I1); et
un deuxième circuit (P13, P14; N14, N15) pour fournir la deuxième tension d'alimentation en énergie au premier et au second des circuits inverseurs,
caractérisé par un deuxième transistor MOS (N15 ou P14) d'un premier type de conductibilité en parallèle avec ledit premier transistor MOS (N14 ou P13) et ayant une électrode de grille alimentée avec le signal de sortie du second circuit inverseur (I2).

2. Circuit amplificateur selon la revendication 1, dans lequel la première tension d'alimentation en énergie (Vss) est plus basse que la deuxième tension d'alimentation en énergie (VDD), et le premier et le deuxième transistor MOS (N14, N15) sont des transistors MOS du type N.

3. Circuit amplificateur selon la revendication 1, dans lequel la première tension d'alimentation en énergie (VDD) est plus élevée que la deuxième tension d'alimentation en énergie (Vss), et le premier et le deuxième transistor MOS (P13, P14) sont des transistors MOS du type P.

4. Circuit amplificateur selon la revendication 2 ou la revendication 3. dans lequel le premier circuit inverseur (I1) comprend;

un troisième transistor MOS (N11 ou P11) du premier type de conductibilité ayant une électrode de source alimentée par la première tension d'alimentation en énergie (Vss ou VDD), une électrode de drain et une électrode de grille alimentée avec le premier signal d'entrée;

un quatrième transistor MOS (P11 ou N11) d'un deuxième type de conductibilité ayant une électrode de source alimentée par la deuxième tension d'alimentation en énergie (VDD ou Vss), une électrode de drain connectée à l'électrode de drain du troisième transistor MOS et une électrode de grille alimentée par le premier signal d'entrée; et

un second circuit inverseur (I2) comprenant: un cinquième transistor MOS (N12 ou P12) du premier type de conductibilité ayant une électrode de source alimentée par la première tension d'alimentation en énergie, une électrode de drain et une électrode de grille alimentée avec le second signal d'entrée, un sixième transistor MOS (P12 ou N12) du deuxième type de conductibilité ayant une électrode de source alimentée par la deuxième tension d'alimentation en énergie, une électrode de drain connectée à l'électrode de drain du cinquième transistor MOS et une électrode de grille alimentée avec le second signal d'entrée.

5. Circuit amplificateur selon la revendication 2, dans lequel le premier circuit inverseur (I1) comprend un troisième transistor MOS (N11) du premier type de conductibilité ayant une électrode de source alimentée par la première tension d'alimentation en énergie (Vss), une électrode de drain et une électrode de grille alimentée avec le premier signal d'entrée, et un quatrième transistor MOS (P11) d'un deuxième type de conductibilité ayant une électrode de source alimentée par la deuxième tension d'alimentation en énergie (VDD), une électrode de drain connectée à l'électrode de drain du troisième transistor MOS et une électrode de grille alimentée par la première tension d'alimentation en énergie (Vss); et

le second circuit inverseur (I2) comprend un cinquième transistor MOS (N12) du premier type de conductibilité ayant une électrode de source alimentée par la première tension d'alimentation en énergie (Vss), une électrode de drain et une électrode de grille alimentés avec le second signal d'entrée, un sixième transistor MOS (P12) du deuxième type de conductibilité ayant une électrode source alimentée par la deuxième tension d'alimentation en énergie (VDD), une électrode de drain connectée à l'électrode de drain du cinquième transistor MOS et une électrode de grille alimentée par la deuxième tension d'alimentation en énergie (Vss).

6. Circuit amplificateur selon la revendication 3, dans lequel le premier circuit inverseur (I1) comprend un troisième transistor MOS (N11) du deuxième type de conductibilité ayant une électrode de source alimentée par la deuxième tension d'alimentation en énergie (Vss), une électrode de drain et une électrode de grille alimentée avec le premier signal d'entrées et un quatrième transistor MOS (P11) du premier type de conductibilité ayant une électrode de source alimentée par la première tension d'alimentation en énergie (VDD), une électrode de drain connectée à l'électrode de drain du troisième transistor MOS et une électrode de grille alimentée par la deuxième tension d'alimentation en énergie (Vss), et

le second circuit inverseur (I2) comprend un cinquième transistor MOS (N12) du deuxième type de conductibilité ayant une électrode de source alimentée avec la deuxième tension d'alimentation en énergie (Vss), une électrode de drain et une électrode de grille alimentée par le second signal d'entrée, un sixième transistor MOS (P12) du premier type de conductibilité ayant une électrode de source alimentée par la première tension d'alimentation en énergie (VDD), une électrode de drain connectée à l'électrode de drain du cinquième transistor MOS et une électrode de grille alimentée par la deuxième tension d'alimentation en énergie (Vss).

7. Circuit amplificateur selon la revendication 2, dans lequel le premier circuit inverseur (I1) comprend un troisième transistor MOS (N11) du premier type de conductibilité ayant une électrode de source alimentée avec la première tension d'alimentation en énergie (Vss), une électrode de drain et une électrode de grille alimentée par le premier signal d'entrée, une première résistance (R1) ayant une première borne alimentée par la deuxième tension d'alimentation en énergie (VDD) et une deuxième borne connectée à l'électrode de drain du troisième transistor MOS (N11); et

le second circuit inverseur (I2) comprend un quatrième transistor MOS (N12) du premier type de conductibilité ayant une électrode de source alimentée par la première tension d'alimentation en énergie (Vss), une électrode de drain et une électrode de grille alimentée avec le second signal d'entrée, une deuxième résistance (R2) ayant une troisième borne alimentée par la deuxième tension d'alimentation en énergie (VDD), et une quatrième borne connectée à l'électrode de drain du quatrième transistor MOS (N12).

8. Circuit amplificateur selon la revendication 3, dans lequel le premier circuit inverseur (I1) comprend un troisième transistor MOS (N11) d'un deuxième type de conductibilité ayant une électrode de source alimentée avec la deuxième tension d'alimentation en énergie (Vss), une électrode de drain et une électrode de grille alimentée par le premier signal d'entrée, une première résistance (R1) ayant une première borne alimentée par la première tension d'alimentation en énergie (VDD) et une deuxième borne connectée à l'électrode de drain du troisième transistor MOS (N11); et

le second circuit inverseur (I2) comprend un quatrième transistor MOS (N12) du deuxième type de conductibilité ayant une électrode de source alimentée par la première tension d'alimentation en énergie (VDD), une électrode de drain et une électrode de grille alimentée avec le second signal d'entrée, une deuxième résistance (R2) ayant une troisième borne alimentée par la première tension d'alimentation en énergie (VDD), et une quatrième borne connectée à l'électrode de drain du quatrième transistor MOS (N12).

9. Circuit amplificateur selon la revendication 1, comprenant ledit deuxième circuit (P13, P14; N14, N15) pour fournir la deuxième tension d'alimentation en énergie au premier et au second des circuits inverseurs, incluant un troisième transistor MOS (P13, N14)) d'un deuxième type de conductibilité ayant une électrode de grille alimentée avec le signal de sortie du premier circuit inverseur et un quatrième transistor MOS (P14, N15) du deuxième type de conductibilité ayant une électrode de grille alimentée avec le signal de sortie du second circuit inverseur.

10. Circuit amplificateur selon la revendication 9, dans lequel le premier circuit inverseur comprend un cinquième transistor MOS (N11) du premier type de conductibilité ayant une électrode de source alimentée par la première tension d'alimentation en énergie, une électrode de drain et une électrode de grille alimentée avec le premier signal d'entrée, un sixième transistor MOS (P11) du deuxième type de conductibilité ayant une électrode de source alimentée par la deuxième tension d'alimentation en énergie, une électrode de drain connectée à l'électrode de drain du cinquième transistor MOS et une électrode de grille; et

le second circuit inverseur (I2) comprend un septième transistor MOS (N12) du premier type de conductibilité ayant une électrode de source alimentée par la première tension d'alimentation en énergie, une électrode de drain et une électrode de grille alimentée avec le second signal d'entrée, un huitième transistor MOS (P12) du deuxième type de conductibilité ayant une électrode de source alimentée par la deuxième tension d'alimentation en énergie, une électrode de drain connectée à l'électrode de drain du septième transistor MOS et une électrode de grille et les électrodes de grille des sixième et du huitième des transistors MOS sont alimentées soit avec le premier et respectivement le second signal d'entrée, soit par la première tension d'alimentation en énergie.

11. Circuit amplificateur selon la revendication 9, dans lequel le premier circuit inverseur comprend un cinquième transistor MOS (N11) du premier type de conductibilité ayant une électrode de source alimentée avec la première tension d'alimentation en énergie, une électrode de drain et une électrode de grille alimentée par le premier signal d'entrée, une première résistance (R1) ayant une première borne connectée à l'électrode de drain du cinquième transistor MOS et une deuxième borne alimentée par la deuxième tension d'alimentation en énergie;

le second circuit inverseur comprend un sixième transistor MOS (N12) du premier type de conductibilité ayant une électrode de source alimentée avec la première tension d'alimentation en énergie, une électrode de drain et une électrode de grille alimentée par le second signal d'entrée, une deuxième résistance (R2) ayant une troisième borne connectée à l'électrode de drain du sixième transistor et une quatrième borne alimentée par la deuxième tension d'alimentation en énergie.

FIG.1

FIG.2

FIG.3

FIG.4

FIG.5

FIG.6

FIG.7

FIG.8

FIG.9

FIG.10

FIG.11

FIG.12